# EUROPÄISCHE PATENTSCHRIFT

(11) **EP 0 839 400 B1**
(45) Veröffentlichungstag und Bekanntmachung des Hinweises auf die Patenterteilung: **04.06.2003**
(21) Anmeldenummer: 96923857.5
(22) Anmeldetag: 16.07.1996
(51) Int. Cl.: H01S 5/02, H01S 5/32

(54) **HALBLEITERLASERCHIP UND INFRAROT-EMITTER-BAUELEMENT**
SEMICONDUCTOR LASER CHIP AND INFRARED EMITTER COMPONENT
PUCE LASER A SEMI-CONDUCTEUR ET COMPOSANT EMETTEUR D'INFRAROUGES

(30) Priorität: 19.07.1995 DE 19526389
(43) Veröffentlichungstag der Anmeldung: 06.05.1998
(73) Patentinhaber: Osram Opto Semiconductors GmbH & Co. OHG, 93049 Regensburg (DE)
(72) Erfinder: BOGNER, Georg, D-93138 Hainsacker (DE); BRUNNER, Herbert, D-93047 Regensburg (DE); HAAS, Heinz, D-93059 Regensburg (DE); LUFT, Johann, D-93195 Wolfsegg (DE); NIRSCHL, Ernst, D-93173 Wenzenbach (DE); SPAETH, Werner, D-83607 Holzkirchen (DE); STATH, Norbert, D-93049 Regensburg (DE); TEICH, Wolfgang, D-93051 Regensburg (DE)
(74) Vertreter: Epping, Wilhelm, Dipl.-Ing.
(86) Internationale Anmeldenummer: DE9601295
(87) Internationale Veröffentlichungsnummer: WO97004509

(56) Entgegenhaltungen:
- JP-A- 1 256 188
- US-A- 4 255 688
- LANG H ET AL: "GAAS/ALGAAS QUANTUM WELL LASER FOR HIGH-SPEED APPLICATIONS" IEE PROCEEDINGS J. OPTOELECTRONICS, Bd. 138, Nr. 2, 1. April 1991 (1991-04-01), Seiten 117-121, XP000226514
- C.A. WANG ET AL: "High power high temperature InGaAs-AlGaAs strained layer quantum well diode lasers" ELECTRONICS LETTERS, Bd. 30, Nr. 8, 14. April 1994 (1994-04-14), Seiten 646-648, XP000451513 STEVENAGE GB in der Anmeldung erwähnt
- XIAO J W: "CWR6 1.65-MA THRESHOLD CURRENT ON SHORT CAVITY UNCOATED STRAINED- LAYER INGAAS-GAAS MQW LASERS" PROCEEDINGS OF THE CONFERENCE ON LASERS AND ELECTRO OPTICS (CLEO), ANAHEIM, MAY 10 - 15, 1992, Bd. 12, 10. Mai 1992 (1992-05-10), Seiten 380-381, XP000351583 INSTITUTE OF ELECTRICAL AND ELECTRONICS ENGINEERS
- TSANG W T ET AL: "LOW-THRESHOLD INGAAS STRAINED-LAYER QUANTUM WELL LASERS ( =0.98 UM) WITH GAINP CLADDING LAYERS PREPARED BY CHEMICAL BEAM EPITAXY" APPLIED PHYSICS LETTERS, Bd. 61, Nr. 7, 17. August 1992 (1992-08-17), Seiten 755-757, XP000293591
- BOUR D P ET AL: "TENSILE-STRAINED ALGAASP- AND INGAASP-(ALGA)0.5IN0.5P QUANTUM WELL LASER DIODES FOR TM-MODE EMISSION IN THE WAVELENGTH RANGE 650 < < 850 NM" IEEE PHOTONICS TECHNOLOGY LETTERS, Bd. 6, Nr. 11, 1. November 1994 (1994-11-01), Seiten 1283-1285, XP000485726
- PATENT ABSTRACTS OF JAPAN vol. 002, no. 027 (E-016), 21. Februar 1978 (1978-02-21) & JP 52 149081 A (NIPPON TELEGR & TELEPH CORP), 10. Dezember 1977 (1977-12-10)
- PATENT ABSTRACTS OF JAPAN vol. 011, no. 355 (E-558), 19. November 1987 (1987-11-19) & JP 62 130573 A (TOYODA GOSEI CO LTD), 12. Juni 1987 (1987-06-12)
- PATENT ABSTRACTS OF JAPAN vol. 018, no. 144 (E-1521), 10. März 1994 (1994-03-10) & JP 05 327026 A (SHARP CORP), 10. Dezember 1993 (1993-12-10)
- PATENT ABSTRACTS OF JAPAN vol. 012, no. 127 (E-602), 20. April 1988 (1988-04-20) & JP 62 252181 A (STANLEY ELECTRIC CO LTD), 2. November 1987 (1987-11-02)

## Beschreibung

Die Erfindung bezieht sich auf ein Strahlungs-Emitter-Bauelement nach dem Oberbegriff des Anspruchs 1. Ein solchen Bauelement ist aus JP-A-02256188 bekannt. Sie bezieht sich insbesondere auf ein Infrarot-Emitter-Bauelement.

Im Stand der Technik sind als optoelektronische Lumineszenz-Bauelemente zum einen handelsübliche Leuchtdioden, beispielsweise GaAs-Infrarot-Lumineszenzdioden, und zum anderen Halbleiterlaser-Bauelemente bekannt. Die in Massenstückzahlen hergestellten handelsüblichen Leuchtdioden sind aufgrund ihrer begrenzten optischen Eigenschaften dort in der Regel nicht einsetzbar, wo eine höhere Leistung, kürzere Schaltzeiten und geringe Wellenlängenbandbreiten erforderlich sind. Zwar wurde versucht, diese Infrarot-Lumineszenzdioden beispielsweise mit GaAs-GaAlAs-Material mit sogenannten Double-Hetero-Übergängen zur Leistungs- und Datenratensteigerung und mit einem transparentem Substrat zur weiteren Leistungssteigerung weiterzubilden. Trotz dieser Maßnahmen ist der Einsatz solcher Leuchtdioden insbesondere im Computer- und Computerperipheriebereich jedoch bis heute nur stark begrenzt möglich. Dieser Anwendungsbereiche ist bis heute nahezu ausschließlich optoelektronischen Laser-Bauelementen vorbehalten. Aufgrund hoher mechanischer Empfindlichkeit von Halbleiterlaserchips, werden diese bislang in herkömmlicher Art und Weise in den bekannten unverkapselten Metallgehäusen, wie z.B. TO-18-Gehäuse oder SMD-Gehäuse (Surface-Mounted-Design-Gehäuse) montiert. Ein Beispiel für ein solches Metallgehäuse ist in der DE-OS 37 32 075 gezeigt.

Halbleiterlaserchips mit einem Halbleitersubstrat und einer auf dem Halbleitersubstrat ausgebildeten aktiven Laserschicht mit einer Quantenwannenstruktur sind beispielsweise aus den Veröffentlichungen
IEE PROCEEDINGS J. OPTOELECTRONICS, Bd. 138, Nr. 2, 01.04.91, Seiten 117-121, WANG, C. A. et al.: High-power, high temperature InGaAs-AlGaAs strained-layer quantum-well diode lasers; Electronics Letters, Bd. 30, Nr. 8, 14.04.94, Seiten 646-648, Applied Physics Letters, Bd. 61, Nr. 7, 17.08.92, Seiten 755-757,
IEEE Photonics Technology Letters, Bd. 6, Nr. 11, November 1994, Seiten 1283-1285,
Patent Abstracts of Japan, vol. 002, no. 027 (E-016), 21.02.78 & JP-A-52 149 081,
BUGGE, F. et al.: Effect of growth interruption on performance of AlGaAs/InGaAs/GaAs quantum well lasers, Journal of Crystal Growth, Vol. 145, 1994, pp. 907-910; und
KARAKIDA, S. et al.: Metalorganic chemical vapor deposition growth of high-quality and highly uniform strained InGaAs quantum wells in a high-speed rotating-disk reactor, Journal of Crystal Growth, Vol. 145, 1994, pp. 662-667
bekannt.

Der Erfindung liegt die Aufgabe zugrunde, ein Strahlungs-Emitter-Bauelement, insbesondere ein Infrarot-Emitter-Bauelement, zur Verfügung zu stellen, welches höheren Anforderungen bei der Anwendung zur Signalübertragung (insbesondere im Computerbereich) über Luftstrecken genügt und gleichzeitig in einer herkömmlichen, auf Massenstückzahlen ausgelegten Montagelinie mit einer hohen Ausbeute und Zuverlässigkeit der Chips montiert werden kann.

Diese Aufgabe wird durch ein Strahlungs-Emitter-Bauelement gemäß Anspruch 1 gelöst. Vorteilhafte Weiterbildungen sind Gegenstand der abhängigen Ansprüche 2 bis 11.

Der Halbleiterlaserchip gemäß der Erfindung zeichnet sich dadurch aus, daß die erste mit der aktiven Laserschicht elektrisch verbundene Kontaktschicht eine auf der rückseitigen Oberfläche des Halbleitersubstrats ganzflächig ausgebildete, elektrisch leitende Kontaktierung aufweist, und die zweite mit der aktiven Laserschicht elektrisch verbundene Kontaktschicht mit einer auf der vorderseitigen Oberfläche des Halbleiterlaserchips ausgebildeten Bond-Kontaktierungsfläche elektrisch verbunden ist. Zur Umlenkung des seitlich abstrahlenden Laserlichts nach vorne ist der Halbleiterlaserchip in einem wannenförmigen Reflektor des Lumineszenzdiodengehäuses befestigt.

Bei einer vorteilhaften Weiterbildung des erfindungsgemäßen Strahlungs-Emitter-Bauelements ist ein infrarotes Licht emittierender Halbleiterlaserchip verwendet.

In dem optisch transparenten, elektrisch nichtleitenden Material des Lumineszenzdioden(LED)-Gehäuses ist ein darin eingebrachtes Diffusormaterial vorgesehen. Hierbei ist das Diffusormaterial hinsichtlich Art und Konzentration derart ausgebildet bzw. eingebracht, daß sich in Verbindung mit dem im Lumineszenzdioden-Gehäuse verkapselten Halbleiterlaserchip eine Abstrahlcharakteristik ergibt, die vergleichbar ist mit einer handelsüblichen Infrarotleuchtdiode (und nicht mit der eines engwinklig abstrahlenden Laser), oder daß eine Vergrößerung der wirksamen Emissionsfläche bewirkt wird. Durch die Aufweitung und Brechung der Kohärenz des Laserstrahls mit Diffusoroberfläche des Reflektors und Einbringen eines Diffusors in den Plastikverguß zur Streuung des Lichts kann eine mit vorbekannten Infrarot-Lumineszenzdioden vergleichbare Abstrahlcharakteristik erzielt werden, so daß das Licht nicht mehr fokussierbar ist, was zur Steigerung der Augensicherheit vorteilhaft ist.

Dem Prinzip der Erfindung liegt die Erkenntnis zugrunde, einen an sich bekannten Halbleiterlaserchip für Leistungsbetrieb derart weiterzubilden, daß er für die Montage in einer auf Massenstückzahlen ausgelegten Lumineszenzdioden-(LED)-Linie montiert werden kann, um auf diese Weise Halbleiterlaser-Bauelemente in größeren Stückzahlen als bisher möglich in preiswerter Montagetchnik analog zu den handelsüblichen Lumineszenzdioden (LEDs) herstellen zu können. Im Gegensatz zu den üblichen GaAs-Infrarot-LEDs bietet der erfindungsgemäße Halbleiterlaserchip und das erfindungsgemäße Infrarot-Emitter-Bauelement die Vorteile höherer Leistung, höherer Datenrate, höherer Zuverlässigkeit bei ähnlich geringen Herstellungskosten, hoher Störsicherheit und hoher Augensicherheit. Aus diesem Grund erschließt sich mit den erfindungsgemäßen Laserchips bzw. Bauelementen ein neuer Anwendungsbereich insbesondere im Computer- und -peripheriebereich, bei denen insbesondere zur Infrarotsignalübertragung über Luftstrecken insbesondere bei Pulsbetrieb höhere Anforderungen gestellt werden, die mit handelsüblichen IR-LEDs oder auch bisherigen Halbleiterlaser-Bauelementen nicht erfüllt werden konnten.

Gemaß Anspruch 1 besteht die aktive Laserschicht aus einer Quantenwannenstruktur, insbesondere mit mehreren epitaktisch aus der metallorganischen Dampfphase abgeschiedenen Schichten (MOVPE-Epi-Schichten = Metall Organic Vapor Phase-Epi-Schichten). Zur Erzielung einer besonders hohen Leistung, kurzen Schaltzeiten und einem engen Wellenlängenfenster mit weniger Störungen durch Umgebungslicht und sehr geringer Wellenlängenbandbreite kann das MOVPE-Epi-Material eine sogenannte gestrainte Quantenwannen-Struktur aufweisen. Hierbei sind die einzelnen epitaktischen Schichten der aktiven Laserschicht gegeneinander verspannt ausgebildet, d.h. es findet keine Gitteranpassung ("lattice matching") der einzelnen Schichten wie sonst üblich statt, so daß Gitterfehler und Kristallstörungen in den verspannten Schichten unterdrückt, gewissermaßen eingefroren werden. Eine solche gestrainte Quantenwannenstuktur ergibt darüber hinaus auch eine mechanisch robustere und unempfindlichere Laservorrichtung, die eine Montage in gängigen LED-Fertigungslinien mit handelsüblichen LED-Gehäusen mit ausreichend hoher Ausbeute und Zuverlässigkeit der Chips ermöglicht. Die bisherigen Halbleiterlaserchips wiesen unter anderem auch eine hohe mechanische Empfindlichkeit auf, die eine solche robustere Montageart nicht zuließ, sondern in speziellen, kostspieligeren Gehäusetypen wie eingangs erwähnt montiert werden mußten.

Die bei den genannten Anwendungen geforderte höhere Leistung ist insbesondere bei Pulsbetrieb mit keiner herkömmlichen Infrarot-Limineszenzdiode erreichbar. Die kurzen Schaltzeiten sind bei einer herkömmlichen Infrarot-Limineszenzdiode nicht gegeben und erschließen gemäß der Erfindung somit neue Anwendungen speziell im Computerbereich. Die geringe spektrale Bandbreite ermöglicht einen störungsfreien Parallelbetrieb mehrerer Systeme, vor allem in Verbindung mit wellenlängenselektiven Detektoren.

Neben einer InGaAs-Quantenwannenstruktur ist auch die Verwendung von InGaAsP-Quantenwannen-Material mit einer passenden Zusammensetzung möglich, insbesondere mit einer Wellenlänge des Laserlichts bis über 1400 nm, mit dem Vorteil der Störungsfreiheit durch Fremdlicht und einer deutlich geringeren Augengefährdung.

Wie bei den an sich bekannten Infrarot-Lumineszenzdioden kann das Halbleitersubstrat ein GaAs-Substrat darstellen, dem Prinzip der Erfindung folgend allerdings mit einer höheren Versetzungsdichte, jedenfalls soweit eine inakzeptable Alterung vermieden wird, mit dem Vorteil der niedrigeren Kosten.

Die erfindungsgemäße Rückseitenmetallisierung des Halbleitersubstrats ermöglicht eine Klebeverbindung des Halbleiterlaserchips in den für Lumineszenzdioden-Gehäuse üblichen Wannenreflektor, wobei der Chip mit einem optisch transparenten Kunststoff hermetisch analog einer LED eingegossen wird. Weiterhin ist die zweite mit der aktiven Laserschicht elektrisch verbundene Kontaktschicht mit einer auf der vorderseitigen Oberfläche der Halbleiterlaserchip ausgebildeten Bond-Kontaktierungsfläche elektrisch verbunden, so daß eine problemlose Verarbeitung des Halbleiterlaserchips in der LED-Montagelinie vermittels Drahtbonden mit einem Draht aus Aluminium oder Gold, und verbunden hiermit eine bessere Erkennbarkeit und Bondsicherheit gewährleistet werden kann.

Bei einer weiteren Ausgestaltung können die bisher üblichen Beschichtungen der Laserspiegel ohne inakzeptable Alterung weggelassen werden, mit dem Vorteil einer für LED-Chips üblichen Anordnung des Halbleiterlaserchips für das Abnehmen von der Montagefolie, womit wiederum Kostenvorteile bei der Montage erzielt werden können.

In der Zeichnung ist ein Ausführungsbeispiel der Erfindung näher erläutert. Es zeigt.
Figur 1 eine schematische Schnittansicht des erfindungsgemäßen Halbleiterlaserchips;
Figur 2 eine schematische Draufsicht auf einen erfindungsgemäßen Halbleiterlaserchip;
Figur 3 eine schematische Schnittansicht eines Infrarot-Emitter-Bauelementes mit einem Lumineszenzdioden-Gehäuse; und
Figur 4 die Abstrahlcharakteristik des erfindungsgemäßen Infrarot-Emitter-Bauelementes.

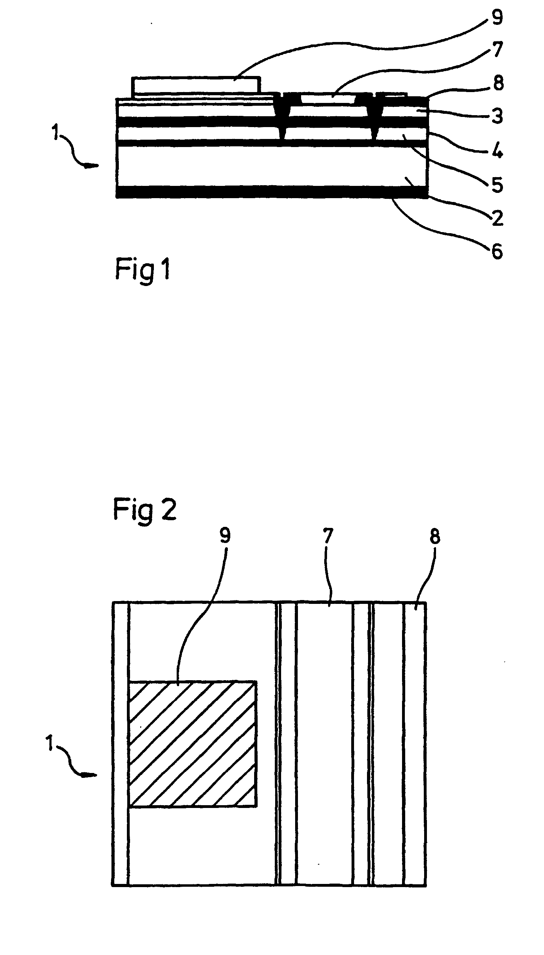

Die Figuren 1 und 2 zeigen ein Ausführungsbeispiel eines erfindungsgemäßen Halbleiterlaserchips 1 mit einem Halbleitersubstrat 2, einer auf dem Halbleitersubstrat 2 ausgebildeten aktiven Laserschicht bestehend aus einer GaAlAs p-Epitaxieschicht 3, einer InGaAs-Quantenwannen-Schicht 4, sowie einer GaAlAs n-Epitaxieschicht 5, und jeweils mit der aktiven Laserschicht elektrisch verbundenen ersten Kontaktschicht 6 vom n-Typ und einer zweiten Kontaktschicht 7 vom p-Typ. Die Bezugsziffer 8 bezeichnet eine vorliegend aus Al₂O₃ bestehenden Isolationsschicht. Erfindungsgemäß ist die erste Kontaktschicht 6 als eine auf der rückseitigen Oberfläche des Halbleitersubstrats 2 ganzflächig ausgebildeten, elektrisch leitenden Kontaktierung ausgebildet. Des weiteren ist eine auf der vorderseitigen Oberfläche des Halbleiterlaserchips ausgebildete Bond-Kontaktierungsfläche 9 vorgesehen, die mit der zweiten Kontaktschicht 7 elektrisch verbunden ist. Die annähernd quadratisch ausgebildete Bond-Kontaktierungsfläche 9 besitzt gemäß Fig. 2 eine ungefähre Seitenlänge von 130 µm. Die weiteren Abmessungen des Halbleiterlaserchips betragen etwa 100 µm in der Stärke, etwa 300 µm in der Breite und etwa 320 µm in der Länge.

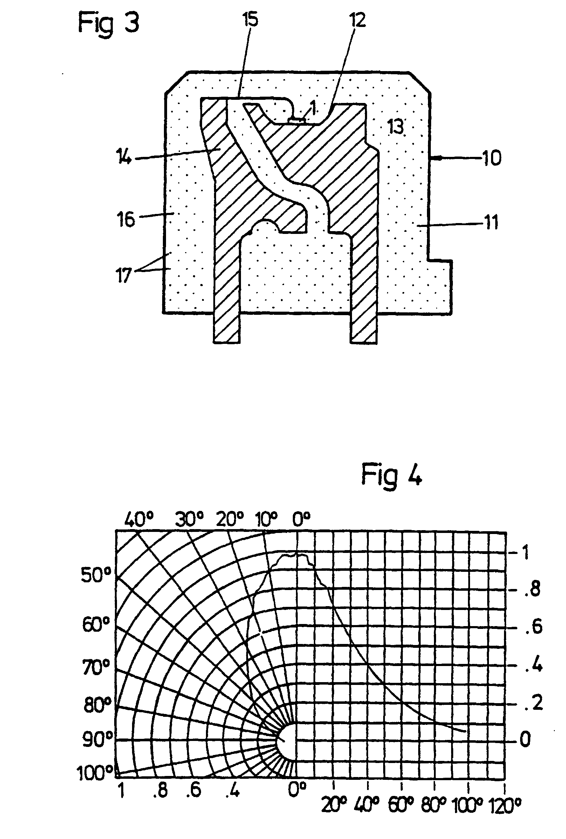

Fig. 3 zeigt das erfindungsgemäße Infrarot-Emitter-Bauelement 10 mit dem in einem handelsüblichen Lumineszenzdioden-Gehäuse 11 verkapselten Halbleiterlaserchip 1. Der Chip 1 ist mit der auf der rückseitigen Oberfläche des Substrats 2 ganzflächig ausgebildeten, elektrisch leitenden Kontaktierung 6 innerhalb eines wannenförmigen Reflektors 12 des einen Elektrodenanschlusses 13 verklebt und sichert auf diese Weise den elektrischen Kontakt. Der zweite Elektrodenanschluß 14 ist elektrisch über einen Bond-Draht 15 aus Al oder Au mit der Bond-Kontaktierungsfläche 7 der Halbleiterlaserchip verbunden. Das LED-Gehäuse 11 besitzt ein optisch transparentes, elektrisch nichtleitendes Verkapselungsmaterial 16, welches insbesondere aus Kunststoff besteht. In dem Verkapslungsmaterial 16 ist ein in Figur 3 durch Punkte angedeutetes Diffusormaterial 17 eingebracht.

Das Gehäuse 11 kann beispielsweise ein handelsübliches LED-Gehäuse vom Typ Siemens SFH 495p (5 mm, T1 3/4, Plan, schwarz eingefärbt, 2,54 mm Raster, Kathodenkennzeichnung: kürzerer Anschluß) sein. Das erfindungsgemäße Bauelement kann auch gegurtet lieferbar sein.

Erfindungsgemäß ist somit ein stimuliertes Emitter-Bauelement mit sehr hohem Wirkungsgrad als Laserdiode in einem diffusem Gehäuse vorgesehen, welches insbesondere für Impulsbetrieb bei hohen Strömen geeignet ist, und sich durch eine hohe Zuverlässigkeit auszeichnet.

## Patentansprüche

1. Strahlungs-Emitter-Bauelement mit einem Halbleiterlaserchip, der ein Halbleitersubstrat (2), eine auf dem Halbleitersubstrat (2) ausgebildete aktive Laserschicht (3,4,5) und mindestens eine erste und eine zweite Kontaktschicht (6, 7) aufweist, die jeweils mit der aktiven Laserschicht (3, 4, 5) elektrisch leitend verbunden sind, wobei die erste Kontaktschicht (6) als eine auf der rückseitigen Oberfläche des Halbleitersubstrats (2) ganzflächig ausgebildete, elektrisch leitende Kontaktierung ausgebildet ist, und die zweite Kontaktschicht (7) mit einer auf der vorderseitigen Oberfläche des Halbleiterlaserchips ausgebildeten Bond-Kontaktierungsfläche (9) elektrisch verbunden ist,
und einem Lumineszenzdioden(LED)-Gehäuse (11), in dem der Halbleiterlaserchip verkapselt ist,
**dadurch gekennzeichnet, daß**
die aktive Laserschicht eine Quantenwannenstruktur enthält, und die Verkapselung des Lumineszenzdioden(LED)-Gehäuses (11) ein optisch transparentes, elektrisch nichtleitendes Material (16) aufweist,
in das ein Diffusormaterial (17) eingebracht ist, und daß innerhalb des Lumineszenzdioden(LED)-Gehäuses (11) eine Reflektoreinrichtung zur Umlenkung des vom Halbleiterlaserchip (1) abgestrahlten Laserlichts vorgesehen ist.

2. Strahlungs-Emitter-Bauelement nach Anspruch 1,
**dadurch gekennzeichnet, daß**
das optisch transparente, elektrisch nichtleitende Material (16) ein Kunststoffmaterial ist.

3. Strahlungs-Emitter-Bauelement nach Anspruch 1 oder 2,
**dadurch gekennzeichnet, daß**
die aktive Laserschicht (3, 4, 5) ein durch Abscheidung aus der metallorganischen Dampfphase herstellbares epitaktisches Material aufweist.

4. Strahlungs-Emitter-Bauelement nach einem der Ansprüche 1 bis 3,
**dadurch gekennzeichnet, daß**
die aktive Laserschicht (3, 4, 5) aus mehreren Schichten ausgebildet ist.

5. Strahlungs-Emitter-Bauelement nach Anspruch 4,
**dadurch gekennzeichnet, daß**
die aktive Laserschicht (3, 4, 5) zumindest drei epitaktisch aufgebrachte Schichten mit der Schichtenfolge GaAlAs-InGaAs-GaAlAs oder GaAlAs-InGaAsP-GaAlAs aufweist.

6. Strahlungs-Emitter-Bauelement nach Anspruch 4 oder 5,
**dadurch gekennzeichnet, daß**
die einzelnen epitaktischen Schichten der aktiven Laserschicht (3, 4, 5) gegeneinander verspannt sind.

7. Strahlungs-Emitter-Bauelement nach Anspruch 1 bis 6,
**dadurch gekennzeichnet, daß**
das Halbleitersubstrat (2) ein GaAs-Substrat darstellt.

8. Strahlungs-Emitter-Bauelement nach Anspruch 7,
**dadurch gekennzeichnet, daß**
das Halbleitersubstrat (2) eine relativ hohe Versetzungsdichte aufweist.

9. Strahlungs-Emitter-Bauelement nach einem der Ansprüche 1 bis 8,
**dadurch gekennzeichnet, daß**
das Lumineszenzdioden(LED)-Gehäuse (11) zwei Elektrodenanschlüsse (13, 14) aufweist und einer der beiden Elektrodenanschlüsse (13,14) als Reflektoreinrichtung einen wannenförmigen Reflektor (12) aufweist, in welchem der Halbleiterlaserchip (1) befestigt ist.

10. Strahlungs-Emitter-Bauelement nach Anspruch 9,
**dadurch gekennzeichnet, daß**
der Halbleiterlaserchip (1) mit seiner auf der rückseitigen Oberfläche des Halbleitersubstrates ganzflächig ausgebildeten elektrisch leitenden Kontaktierung mit dem wannenförmigen Reflektor (12) des Lumineszenzdioden-(LED)-Gehäuses (11) elektrisch leitend verbunden ist.

11. Strahlungs-Emitter-Bauelement nach einem der Ansprüche 1 bis 10,
**dadurch gekennzeichnet, daß**
der Halbleiterlaserchip (1) infrarotes Laserlicht abstrahlt.

## Claims

1. Radiation emitter component having a semiconductor laser chip which has a semiconductor substrate (2), an active laser layer (3, 4, 5) formed on the semiconductor substrate (2) and at least one first and one second contact layer (6, 7), which are in each case electrically conductively connected to the active laser layer (3, 4, 5), the first contact layer (6) being formed as an electrically conductive contact connection formed over the whole area on the rear-side surface of the semiconductor substrate (2) and the second contact layer (7) being electrically connected to a bonding contact-connection area (9) formed on the front-side surface of the semiconductor laser chip, and having a light-emitting diode (LED) housing (11) in which the semiconductor laser chip is encapsulated, **characterized in that** the active laser layer contains a quantum well structure, and the encapsulation of the light-emitting diode (LED) housing (11) has an optically transparent, electrically non-conducting material (16), into which a diffuser material (17) is introduced, and **in that** a device reflector is provided within the light-emitting diode (LED) housing (11) for deflecting the laser light radiated by the semiconductor laser chip (1).

2. Radiation emitter component according to Claim 1,
**characterized in that**
the optically transparent, electrically non-conducting material (16) is a plastics material.

3. Radiation emitter component according to Claim 1 or 2,
**characterized in that**
the active laser layer (3, 4, 5) has an epitaxial material which can be produced by deposition from the metal-organic vapour phase.

4. Radiation emitter component according to one of Claims 1 to 3,
**characterized in that**
the active laser layer (3, 4, 5) is formed from a plurality of layers.

5. Radiation emitter component according to Claim 4,
**characterized in that**
the active laser layer (3, 4, 5) has at least three epitaxially applied layers with the layer sequence GaAlAs-InGaAs-GaAlAs or GaAlAs-InGaAsP-GaAlAs.

6. Radiation emitter component according to Claim 4 or 5,
**characterized in that**
the individual epitaxial layers of the active laser layer (3, 4, 5) are strained with respect to one another.

7. Radiation emitter component according to Claims 1 to 6,
**characterized in that**
the semiconductor substrate (2) represents a GaAs substrate.

8. Radiation emitter component according to Claim 7,
**characterized in that**
the semiconductor substrate (2) has a relatively high dislocation density.

9. Radiation emitter component according to one of Claims 1 to 8,
**characterized in that**
the light-emitting diode (LED) housing (11) has two electrode terminals (13, 14) and one of the two electrode terminals (13, 14) has a well-type reflector (12) as reflector device, the semiconductor laser chip (1) being fixed in the said reflector.

10. Radiation emitter component according to Claim 9,
**characterized in that**
the semiconductor laser chip (1) is electrically conductively connected to the well-type reflector (12) of the light-emitting diode (LED) housing (11) by its conductive contact connection formed over the whole area on the rear-side surface of the semiconductor substrate.

11. Radiation emitter component according to one of Claims 1 to 10,
**characterized in that**
the semiconductor laser chip (1) radiates infrared laser light.

## Revendications

1. Composant formant émetteur de rayonnement et comprenant une puce laser à semi-conducteur, qui a un substrat (2), une couche (3,4,5) laser active constituée sur le substrat (2) semi-conducteur et au moins une première et une deuxième couches (6,7) de contact qui sont reliées respectivement d'une manière conductrice de l'électricité à la couche (3,4,5) laser active, la première couche (6) de contact étant constituée sous la forme d'une mise en contact conductrice de l'électricité et formée sur toute la surface de la face arrière du substrat (2) semi-conducteur et la deuxième couche (7) de contact étant reliée électriquement à une surface (9) de mise en contact par fil constituée sur la face avant de la puce laser à semi-conducteur,
et un boîtier (11) de diode électroluminescente (LED), dans lequel la puce laser à semi-conducteur est encapsulée,
**caractérisé en ce que**,
la couche laser active contient une structure de puits quantique et l'encapsulation du boîtier (11) de diode électroluminescente (LED) présente un matériau (16) qui est transparent du point de vue optique et qui n'est pas conducteur de l'électricité,
auquel est incorporé un matériau (17) formant diffuseur, et
**en ce que** dans le boîtier (11) de diode électroluminescente (LED) est prévu un dispositif formant réflecteur pour dévier la lumière laser émise par la puce (1 ) laser à semi-conducteur.

2. Composant formant émetteur de rayonnement suivant la revendication 1, **caractérisé en ce que**
le matériau (16) qui est transparent du point de vue optique et qui n'est pas conducteur de l'électricité est une matière plastique.

3. Composant formant émetteur de rayonnement suivant la revendication 1 ou 2 **caractérisé en ce que**
la couche (3,4,5) laser active comprend un matériau épitaxial pouvant être produit par dépôt à partir d'une phase vapeur organométallique.

4. Composant formant émetteur de rayonnement suivant l'une des revendications 1 à 3, **caractérisé en ce que**
la couche (3,4,5) laser active est constituée de plusieurs couches.

5. Composant formant émetteur de rayonnement suivant la revendication 4, **caractérisé en ce que**
la couche (3,4,5) laser active comprend au moins trois couches déposées par épitaxie ayant la succession de couches GaAlAs-lnGaAs-GaAlAs ou GaAlAs-lnGaAsP-GaAlAs.

6. Composant formant émetteur de rayonnement suivant la revendication 4 ou 5, **caractérisé en ce que**
les couches épitaxiales de la couche (3,4,5) laser active sont serrées les unes contre les autres.

7. Composant formant émetteur de rayonnement suivant les revendications 1 à 6, **caractérisé en ce que**
le substrat (2) semi-conducteur est un substrat en GaAs.

8. Composant formant émetteur de rayonnement suivant la revendication 7, **caractérisé en ce que**
le substrat (2) semi-conducteur a une densité de dislocation relativement grande.

9. Composant formant émetteur de rayonnement suivant l'une des revendications 1 à 8, **caractérisé en ce que**
le boîtier (11) de diode électroluminescente (LED) a deux bornes (13,14) d'électrode et l'une des deux bornes (13,14) d'électrode a comme dispositif formant réflecteur un réflecteur (12) en forme de cuvette dans lequel est fixée la puce (1 ) laser à semi-conducteur.

10. Composant formant émetteur de rayonnement suivant la revendication 9, **caractérisé en ce que**
la puce (1) laser à semi-conducteur est reliée d'une manière conductrice de l'électricité, par sa mise en contact conductrice de l'électricité formée sur toute la surface sur la face arrière du substrat semi-conducteur, au réflecteur (12) en forme de cuvette du boîtier (11) de diode électroluminescente (LED).

11. Composant formant émetteur de rayonnement suivant l'une des revendications 1 à 10, **caractérisé en ce que**
la puce (1) laser à semi-conducteur émet de la lumière infrarouge.
